# EUROPEAN PATENT APPLICATION

(11) **EP 4 822 244 A1**
(43) Date of publication of application: **14.10.2026**
(21) Application number: 24901032.3
(22) Date of filing: 03.12.2024
(51) Int. Cl.: F21K 9/238, F21V 29/74, H10H 20/857, H10H 20/85, F21K 9/90

(54) **LIGHTING DEVICE**

(30) Priority: 07.12.2023 KR 20230177075
(71) Applicant: LG Innotek Co., Ltd., Seoul 07796 (KR)
(72) Inventor: LEE, Jun, Seoul 07796 (KR); LEE, Hee Jung, Seoul 07796 (KR); KIM, Won Jin, Seoul 07796 (KR)
(74) Representative: Plasseraud IP
(86) International application number: PCT/KR2024/019612
(87) International publication number: WO 2025/121846

(57) **Abstract**

A lighting device disclosed in the invention includes: a heat dissipation plate including a recess portion; a circuit board disposed in the recess portion and having pads; a light source portion on the heat dissipation plate and including light emitting devices and bonding pads; connection members connecting the circuit board and the light source portion; and an insulating member disposed at a lower portion of the connection members, wherein the circuit board and the light source portion are spaced apart from each other in a first direction, the connection members is spaced apart from each other in a second direction orthogonal to the first direction, the connection members is respectively connected between the pads and the bonding pads, the insulating member is disposed between the light source portion and the circuit board, and the insulating member may not contact the pads and the bonding pads.

## Description

### Technical Field

An embodiment relates to a lighting device. An embodiment relates to a vehicle light having a lighting device.

### Background Art

Lighting applications include vehicle lighting, backlights for displays, and backlights for signboards. A light emitting diode (LED) has advantages of low power consumption, semi-permanent lifetime, fast response speed, safety, and environmental friendliness compared to light sources such as fluorescent lamps and incandescent lamps. The light emitting diode is applied to various lighting devices such as various display devices, indoor lights, and outdoor lights. Recently, lamps employing light emitting diodes as a vehicle light source have been proposed. Compared with incandescent lamps, light emitting diodes are advantageous in that power consumption is low. In addition, since light emitting diodes have a small size, a degree of design freedom of a lamp may be increased, and there is economic efficiency due to a semi-permanent lifetime. However, since an emission angle of light emitted from a light emitting diode is small, when a light emitting diode is used as a vehicle lamp, there is a demand for increasing a light emitting area of a lamp using the light emitting diode. As prior art related to a lighting device, Korean Patent Application Publication No. KR10-2023-0010550 published Jan. 19, 2023 is disclosed.

### Disclosure

### Technical Problem

An embodiment of the invention provides a lighting device having enhanced reliability. The embodiment also provides a vehicle light and a headlamp having a lighting device.

### Technical Solution

A lighting device according to an embodiment of an invention comprises: a heat dissipation plate including a recess portion; a circuit board disposed in the recess portion and having a plurality of pads; a light source portion disposed on the heat dissipation plate and including a plurality of light emitting devices and a plurality of bonding pads; a plurality of connection members connecting the circuit board and the light source portion; and an insulating member disposed at a lower portion of the connection members, wherein the circuit board and the light source portion are spaced apart from each other in a first direction, the plurality of connection members are spaced apart from each other in a second direction orthogonal to the first direction, the plurality of connection members are respectively connected between the plurality of pads and the plurality of bonding pads, the insulating member is disposed between the light source portion and the circuit board, and the insulating member may not contact the pads and the bonding pads.

According to an embodiment of the invention, the insulating member may contact the plurality of connection members. The insulating member may not contact the plurality of connection members.

According to an embodiment of the invention, a thickness of the insulating member may be 90% or more of a height of the plurality of connection members, and a height of the plurality of connection members may be a distance from the heat dissipation plate to the connection members.

According to an embodiment of the invention, a region in which the plurality of pads is disposed has a first width in the second direction, a region in which the plurality of bonding pads is disposed has a second width in the second direction, a width of the insulating member in the second direction is 1 time to 1.5 times the first width, and the width of the insulating member may be 1 time to 1.3 times the second width.

According to an embodiment of the invention, a length of the insulating member in the first direction may be 50% to 80% of a length of the connection member. The heat dissipation plate includes a plurality of patterns, and the insulating member may contact the patterns.

A lighting device according to an embodiment of the invention comprises: a heat dissipation plate; a circuit board disposed on the heat dissipation plate and having a plurality of pads; a light source portion disposed on the heat dissipation plate and including a plurality of light emitting devices and a plurality of bonding pads; a plurality of connection members connecting the circuit board and the light source portion; and an insulating member disposed on the heat dissipation plate, wherein the circuit board and the light source portion are spaced apart from each other in a first direction, the plurality of connection members are spaced apart from each other in a second direction orthogonal to the first direction, each of the plurality of connection members includes: one end connected to the plurality of bonding pads; the other end connected to the plurality of pads; and a connection portion connecting the one end and the other end, the connection portion includes a convex portion convex toward the heat dissipation plate, and the insulating member may be disposed at a lower portion of the plurality of connection members.

According to an embodiment of the invention, the lighting device may include a molding portion surrounding the plurality of connection members. The molding portion and the insulating member may include the same material.

According to an embodiment of the invention, the light source portion includes a support member, the light emitting devices are disposed on the support member, the connection portion includes a central portion, a first outer portion, and a second outer portion, the central portion is disposed in a region between a side surface of the support member and a side surface of the circuit board, and the first outer portion and the second outer portion may be disposed in regions other than the region between the side surface of the support member and the side surface of the circuit board. The central portion is convex toward the heat dissipation plate, and the first outer portion and the second outer portion may be convex in a direction opposite to the heat dissipation plate.

According to an embodiment of the invention, the heat dissipation plate includes a groove having a long length in the second direction, and the groove may be disposed between the light source portion and the circuit board. The insulating member is disposed inside the groove and may overlap the plurality of connection members in a vertical direction.

### Advantageous Effects

The lighting device according to an embodiment includes an insulating member. The insulating member supports the connection member. The connection members contact the insulating member. Accordingly, deformation of the connection members due to an external impact may be prevented. Therefore, bonding force among the connection members, the pad, and the bonding pad is improved. The connection members are spaced apart from the insulating member within a predetermined range. Accordingly, deformation of the connection members due to an external impact may be prevented. Therefore, bonding force among the connection member, the pad, and the bonding pad is improved. In addition, the connection members do not contact the insulating member. Accordingly, deformation of a position of the connection members due to a difference in coefficient of thermal expansion between the connection members and the insulating member may be prevented. Therefore, bonding force among the connection members, the pad, and the bonding pad is improved.

According to another embodiment of the invention, the lighting device includes an insulating member. Accordingly, even when the connection members are deformed toward the heat dissipation portion by an external impact, the connection members do not contact the heat dissipation portion due to the insulating member. Therefore, electrical connection between the connection members and the heat dissipation portion may be prevented. In addition, even when a shape or position of the connection members is deformed due to a difference in coefficient of thermal expansion between the connection members and the molding portion, contact between the connection members and the heat dissipation portion may be prevented. Therefore, reliability of the lighting device may be improved.

### Description of Drawings

FIG. 1 is a perspective view illustrating an example of a lighting device according to a first embodiment.
FIG. 2 is a side cross-sectional view of the lighting device of FIG. 1.
FIG. 3 is a perspective view illustrating a light source portion and a circuit board of the lighting device of FIG. 1.
FIG. 4 is a plan view of a lighting device having an insulating member according to an embodiment of the invention.
FIG. 5 illustrates another example of the lighting device of FIG. 4.
FIG. 6 illustrates another example of the lighting device of FIG. 4.
FIG. 7 is a side cross-sectional view taken along line A-A' of the lighting device of FIG. 5.
FIG. 8 is an enlarged view of region A of FIG. 7.
FIG. 9 is a perspective view illustrating an example of a lighting device according to a second embodiment.
FIG. 10 is a side cross-sectional view of the lighting device of FIG. 9.
FIG. 11 is a perspective view illustrating a light source portion and a circuit board of the lighting device of FIG. 9.
FIG. 12 is a plan view of the lighting device of FIG. 11.
FIG. 13 is a side cross-sectional view taken along line B-B' of FIG. 12.
FIG. 14 illustrates another example of the side cross-sectional view taken along line B-B' of the lighting device of FIG. 12.
FIG. 15 is another plan view of the lighting device of FIG. 11.
FIG. 16 is a side cross-sectional view taken along line C-C' of the lighting device of FIG. 15.
FIG. 17 is another plan view of the lighting device of FIG. 11.
FIG. 18 is a side cross-sectional view taken along line D-D' of the lighting device of FIG. 17.
FIG. 19 is another plan view of the lighting device of FIG. 11.
FIG. 20 is a side cross-sectional view taken along line E-E' of the lighting device of FIG. 19.

### Best Mode

Hereinafter, preferred embodiments of the invention will be described in detail with reference to the accompanying drawings. However, the technical idea of the invention is not limited to some of the described embodiments, but can be implemented in various different forms, and if it is within the scope of the technical idea of the invention, one or more of its components may be selectively combined and substituted between embodiments. In addition, terms (including technical and scientific terms) used in the embodiments of the invention, unless explicitly specifically defined and described, may be interpreted as a meaning that may be generally understood by those skilled in the art to which the invention belongs, and terms generally used, such as terms defined in the dictionary, may be interpreted in consideration of the context of the related technology. Terms used in the embodiments of the invention are for describing the embodiments and are not intended to limit the invention. In the present specification, the singular form may include a plural form unless specifically described in the phrase, and may include at least one of all combinations that may be combined as A, B, and C when described as "A and/or at least one (or more than one) of B and C". Also, terms such as first, second, A, B, (a), and (b) may be used to describe components of an embodiment of the invention. These terms are intended only to distinguish the components from other components and are not determined by their nature, sequence, or order. Also, when a component is described as being 'connected', 'coupled' or 'connected' to another component, not only when the component is directly connected, coupled or connected to another component, it may also be 'connected', 'coupled', or 'connected' due to another component between that component and the other component. In addition, when each component is described as being formed or disposed "up (above) or down (bottom)", the up (down) or down (bottom) includes not only when two components are in direct contact with each other, but also when one or more components are formed or disposed between two components. Also, when expressed as "up (above) or down (bottom)", it may include the meaning of not only the upward direction but also the downward direction based on one component.

Hereinafter, a lighting device according to embodiments will be described with reference to the accompanying drawings.

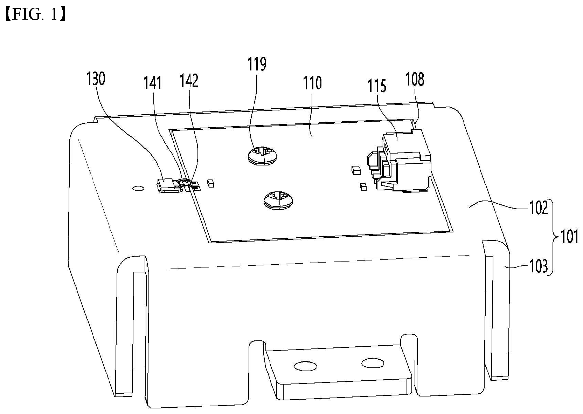

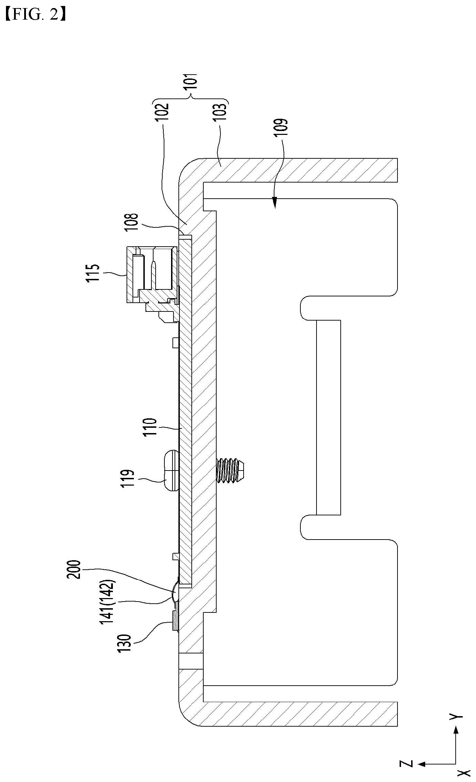

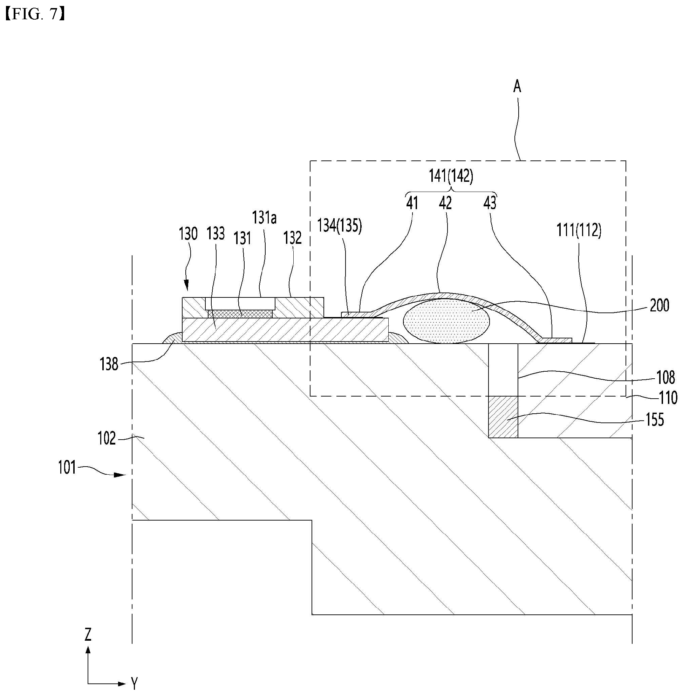

FIGS. 1 to 8 illustrate a lighting device according to a first embodiment. Referring to FIGS. 1 to 8, the lighting device according to the first embodiment includes a heat dissipation plate 101, a circuit board 110, a light source portion 130, connection members 141 and 142, and an insulating member 200.

The circuit board 110 is disposed on the heat dissipation plate 101. The light source portion 130 includes a plurality of light emitting devices 131. The light source portion 130 is disposed on the heat dissipation plate 101. The connection members 141 and 142 connect the light source portion 130 and the circuit board 110. The connection members 141 and 142 electrically connect the light source portion 130 and the circuit board 110. The insulating member 200 is disposed between the connection members 141 and 142 and the heat dissipation plate 101. The insulating member 200 supports the connection members 141 and 142. The insulating member 200 supports a portion of each of the connection members 141 and 142.

The lighting device is applied to various lamp devices requiring illumination. For example, the lighting device may be applied to a vehicular lamp, a household lighting device, or an industrial lighting device. For example, the lighting device may be applied to the vehicular lamp. The lighting device may be applied to a head lamp, a side mirror lamp, a side maker light, a fog lamp, a tail lamp, a brake lamp, a daytime running lamp, an interior vehicle lamp, a door scuff, a rear combination lamp, or a backup lamp. In addition, the lighting device may be applied to indoor or outdoor advertisement devices, display devices, and railway vehicle fields.

The heat dissipation plate 101 supports the circuit board 110. Heat generated from the circuit board 110 is transferred by the heat dissipation plate 101. The heat dissipation plate 101 includes metal. For example, the heat dissipation plate 101 may be formed in a structure in which a single metal layer or a plurality of metal layers are stacked. The heat dissipation plate 101 may be formed as a single layer or multiple layers. The heat dissipation plate 101 may include a ceramic material, AlN, or an aluminum material having an anodized surface layer. The metal layer may include at least one of Al, Ni, Mo, Cu, Cu-alloy, Cu-W, Ag, or Au.

The heat dissipation plate 101 includes a heat dissipation portion 102 and a side portion 103. The heat dissipation portion 102 includes a recess portion 108. The circuit board 110 is disposed in the recess portion 108. An area of the heat dissipation portion 102 may be greater than an area of the circuit board 110. The side portion 103 is bent downward from an edge of the heat dissipation portion 102. One or a plurality of side portions 103 may be disposed along an outer side of the heat dissipation portion 102. An empty space 109 may be provided inside the side portion 103 and a lower portion of the heat dissipation portion 102, or another structure may be coupled thereto. The recess portion 108 is formed to a predetermined depth from an upper surface of the heat dissipation portion 102. A depth of the recess portion 108 may be equal to or less than a thickness of the circuit board 110. A top-view shape of the recess portion 108 may be identical to a top-view shape of the circuit board 110. For example, the top-view shape of the recess portion 108 may include a polygonal shape.

The circuit board 110 is inserted into the recess portion 108. The circuit board 110 may be bonded to a bottom surface of the recess portion 108 by an adhesive member 155. The adhesive member 155 may include a thermally conductive adhesive. An upper surface of the circuit board 110 may be disposed on the same plane as an upper surface of the heat dissipation plate 101. As another example, the upper surface of the circuit board 110 may be disposed higher than the upper surface of the heat dissipation plate 101. The adhesive member 155 is disposed on an outer periphery of the recess portion 108. A surface of the heat dissipation portion 102 may be bonded to the circuit board 110.

The circuit board 110 may include resin or metal. For example, the circuit board 110 may include any one of a ceramic PCB, a metal core PCB, a flexible PCB, and a resin PCB. The circuit board 110 includes a lower metal layer, an upper circuit layer including pads, a protective layer of an insulating material for protecting the upper circuit layer, and an insulating layer between the metal layer and the circuit layer. The circuit board 110 may be provided as an MCPCB in which a metal layer is disposed at a lower portion thereof. In addition, the circuit board 110 may transfer heat to the heat dissipation plate 101.

The circuit board 110 may be fastened to the heat dissipation portion 102 by fastening means 119. The fastening means 119 may include one or more screws. The circuit board 110 and the heat dissipation portion 102 may be fastened and closely attached by the screws. When the circuit board 110 is fixed by the fastening means 119, the adhesive member 155 may be removed. Accordingly, separation of the circuit board 110 may be facilitated. The circuit board 110 may include a plurality of pads. The pads 111 and 112 may include a first pad 111 and a second pad 112 spaced apart from each other. The first pad 111 and the second pad 112 are connected to a connector 115 disposed on an upper portion of the circuit board 110 by the circuit layer of the circuit board 110. The connector 115 may receive a driving signal and power from the outside. The pads 111 and 112 and the connector 115 may be disposed at opposite edges of the circuit board 110. The fastening means 119 may be disposed in a region between the pads 111 and 112 and the connector 115.

The first pad 111 and the second pad 112 are disposed adjacent to one side surface of the circuit board 110. The pads 111 and 112 may be selected from Ti, Ru, Rh, Ir, Mg, Zn, Al, In, Ta, Pd, Co, Ni, Si, Ge, Ag, Au, and optional alloys thereof.

The light source portion 130 is disposed on the heat dissipation portion 102. The light source portion 130 may be adjacent to the recess portion 108. The light source portion 130 may be adjacent to one side surface of the circuit board 110. One side surface of the circuit board 110 may be disposed between the pads 111 and 112 and the light source portion 130. The light source portion 130 and the circuit board 110 may be spaced apart from each other in a first direction Y. The first and second pads 111 and 112 may be spaced apart from each other in a second direction X. The first direction Y is orthogonal to the second direction X. A third direction is a thickness direction of the light source portion 130 and the circuit board 110 and is orthogonal to the first and second directions Y and X.

The light source portion 130 may include a support member 133 and at least one light emitting device 131 disposed on the support member 133. The light source portion 130 may include a resin member 132. The resin member 132 may be disposed on the support member 133. A plurality of light emitting devices 131 may be disposed on the support member 133. The resin member 132 is disposed around the plurality of light emitting devices 131 and may seal side surfaces of the light emitting devices 131. The support member 133 may include a ceramic substrate or a semiconductor substrate. The support member 133 may support the plurality of light emitting devices 131.

The light source portion 130 may include bonding pads 134 and 135. The bonding pads 134 and 135 may be electrically connected to the connection members 141 and 142. The support member 133 may include conductive patterns. The plurality of light emitting devices 131 may be electrically connected by the conductive patterns. The bonding pads 134 and 135 may be electrically connected to the light emitting devices 131 by the conductive patterns. The plurality of light emitting devices 131 may be connected in series or in parallel.

A protective element for protecting the light emitting devices 131 may be disposed on the support member 133. The protective element may be implemented as a thyristor, a Zener diode, or a transient voltage suppression device. Accordingly, the light emitting devices 131 may be protected from electrostatic discharge. The support member 133 may be formed of a ceramic material or an MCPCB material. The light source portion 130 may transfer heat generated from the light emitting devices 131 to the heat dissipation plate 101 through the support member 133. The support member 133 and the heat dissipation plate 101 may be bonded by an adhesive 138. The adhesive 138 may include a thermally conductive adhesive having metal powder or inorganic powder in a resin material. For example, the adhesive 138 may include a thermal interface material. The adhesive 138 may be disposed along a lower surface and lower side surfaces of the support member 133. The adhesive 138 is disposed outside side surfaces of the support member 133 and may contact each side surface of the support member 133.

The plurality of light emitting devices 131 are arranged in one direction or disposed in at least one row. The plurality of light emitting devices 131 may be connected to each other in series. The plurality of light emitting devices 131 may include at least one of a blue LED chip, a green LED chip, or a red LED chip. The plurality of light emitting devices 131 may be flip-chip bonded or wire-bonded. The light emitting devices 131 may include a plurality of semiconductor layers made of a compound semiconductor of Group II and Group VI elements and/or a compound semiconductor of Group III and Group V elements. At least one or all of the plurality of semiconductor layers may include a compound semiconductor such as AlInGaN, InGaN, AlGaN, GaN, GaAs, InGaP, AlInGaP, InP, or InGaAs.

The resin member 132 may include silicone or epoxy. A phosphor layer 131a is disposed on the light emitting device 131 and wavelength-converts light emitted from the light emitting device 131. The resin member 132 may include a transparent layer and/or the phosphor layer 131a on the light emitting device 131. As another example, the phosphor layer 131a may be separately formed from the resin member 132 or disposed on different regions. The resin member 132 may function as a reflective wall around the light emitting device 131 and the transparent layer and/or the phosphor layer 131a. The resin member 132 may further include a convex lens. The phosphor layer may include at least one or two or more of a yellow phosphor, a green phosphor, a blue phosphor, or a red phosphor. The light source portion 130 may emit one or more of blue light, green light, and red light, or may emit white light.

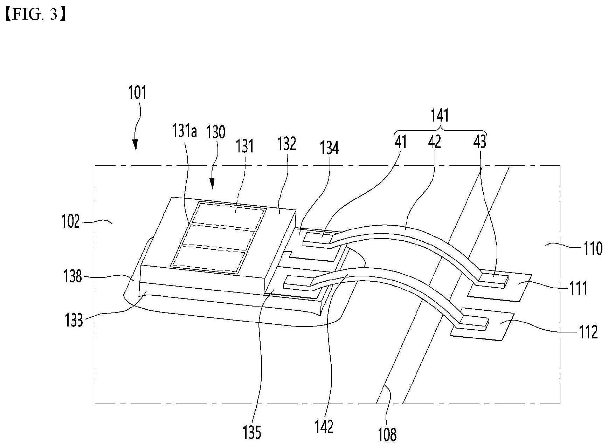

Referring to FIGS. 3 to 6, the light emitting devices 131 are disposed on an upper portion of one side of the support member 133. Bonding pads 134 and 135 are exposed on an upper portion of the other side of the support member 133. The bonding pads 134 and 135 may include a first bonding pad 134 connected to cathodes of the plurality of light emitting devices 131 and a second bonding pad 135 connected to anodes of the plurality of light emitting devices 131. The first bonding pad 134 may have a color-specific mark and function as a cathode terminal, and the second bonding pad 135 may function as an anode terminal. The first bonding pad 134 and the second bonding pad 135 may be selected from Ti, Ru, Rh, Ir, Mg, Zn, Al, In, Ta, Pd, Co, Ni, Si, Ge, Ag, Au, and optional alloys thereof. The first bonding pad 134 and the second bonding pad 135 are disposed on the support member 133 and electrically connected to conductive patterns of the support member 133. Upper surfaces of the first bonding pad 134 and the second bonding pad 135 may be disposed at a height lower than an upper surface of the resin member 132, or may be disposed at a height higher than the upper surface of the resin member 132.

The first bonding pad 134 and the first pad 111 are connected by a first connection member 141. The second bonding pad 135 and the second pad 112 are connected by a second connection member 142. The first connection member 141 and the second connection member 142 may be formed as wires. The first connection member 141 and the second connection member 142 may include at least one of Au, Al, Ag, and Ni. Widths of the first connection member 141 and the second connection member 142 may be greater than thicknesses thereof. That is, the first connection member 141 and the second connection member 142 may be provided as ribbon-shaped wires.

One end 41 of each of the first connection member 141 and the second connection member 142 is bonded to the first bonding pad 134 and the second bonding pad 135, respectively, and the other end 43 thereof is bonded to the first pad 111 and the second pad 112, respectively. The first connection member 141 and the second connection member 142 include a central portion 42 extending from the one end 41 toward the other end 43. The central portion 42 may extend from the other side of the light source portion 130 toward one side of the circuit board 110. The central portion 42 may extend over the recess portion 108 between the circuit board 110 and the heat dissipation portion 102. A height of the one end 41 may be higher than a height of the other end 43. A height of the central portion 42 may be higher than the one end 41.

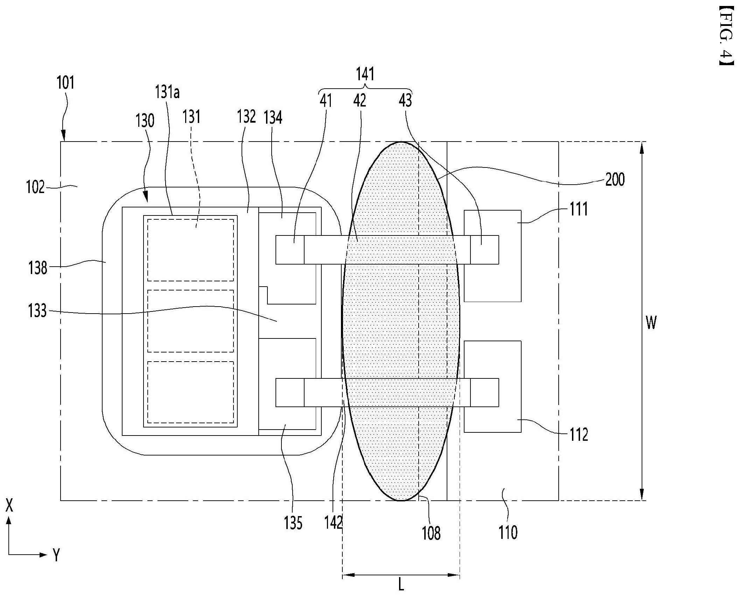

As shown in FIGS. 4 to 7, the light source portion 130 and the circuit board 110 are electrically connected by the first connection member 141 and the second connection member 142. Since the connection members 141 and 142 have a ribbon shape and are provided as wires having a long length in the first direction Y, the connection members 141 and 142 may be deformed by an external impact. Accordingly, electrical connection characteristics between the light source portion 130 and the circuit board 110 may be reduced. In order to prevent such problems, the insulating member 200 according to the embodiment may be disposed between the light source portion 130 and the circuit board 110. In addition, the insulating member 200 may be disposed between the connection members 141 and 142 and the heat dissipation plate 101.

The insulating member 200 includes resin. For example, the insulating member may include epoxy, acrylate, urethane, polyolefin, silicone, or a mixture thereof. The connection members 141 and 142 include metal. Accordingly, when the insulating member 200 covers an entire region of the connection members 141 and 142, connection characteristics of the connection members 141 and 142 may be reduced. More specifically, the insulating member 200 includes a material different from that of the connection members 141 and 142. Accordingly, a coefficient of thermal expansion of the insulating member differs from a coefficient of thermal expansion of the connection members 141 and 142. Accordingly, contraction and expansion characteristics of the insulating member 200 differ from contraction and expansion characteristics of the connection members 141 and 142. Therefore, when a temperature of the lighting device changes, the connection members 141 and 142 may be deformed due to a difference in coefficients of thermal expansion. Accordingly, a portion of the connection members 141 and 142 may be separated from at least one of the pads 111 and 112 and the bonding pads 134 and 135. Accordingly, electrical characteristics and reliability of the lighting device may be reduced.

Therefore, in order to solve the above-described problems, the lighting device according to the embodiment may prevent deterioration in electrical characteristics of the connection members 141 and 142 by using the insulating member 200. Referring to FIGS. 4 to 6, the insulating member 200 is disposed at a lower portion of the connection members 141 and 142. Accordingly, the connection members 141 and 142 are disposed on the insulating member 200. The connection members 141 and 142 may contact the insulating member 200. As another example, the connection members 141 and 142 may be spaced apart from the insulating member 200. As another example, some regions of the connection members 141 and 142 may be spaced apart from the insulating member 200, and other regions thereof may contact the insulating member 200.

Referring to FIG. 4, the insulating member 200 may include a single insulating member. Accordingly, the first connection member 141 and the second connection member 142 may be supported by one insulating member. When the insulating member 200 is a single insulating member, the insulating member 200 may have a shape formed through one resin forming process. That is, the insulating member 200 may have an elliptical shape or a circular shape. In addition, a length L of the insulating member 200 may be greatest at a bottom length in the first direction Y of a central region between the first and second connection members 141 and 142, and may gradually decrease as a distance from the central region in the second direction X increases.

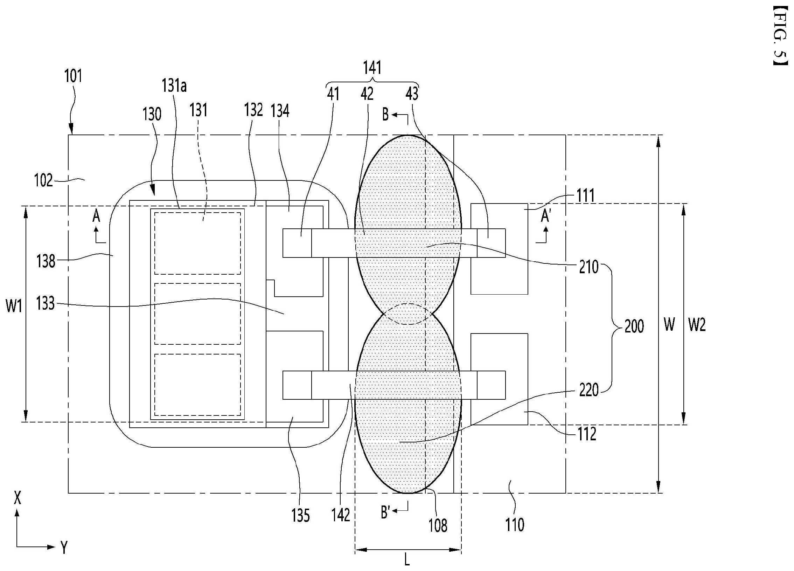

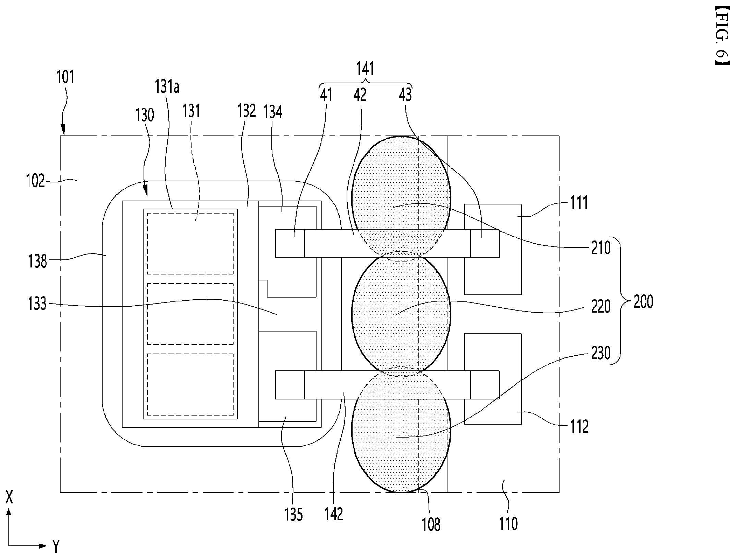

Referring to FIGS. 5 and 6, the insulating member 200 may include a plurality of insulating members. As shown in FIG. 5, the insulating member 200 may include a first insulating member 210 and a second insulating member 220. The first insulating member 210 and the second insulating member 220 may contact or be connected to each other. Each of the first insulating member 210 and the second insulating member 220 may have an elliptical shape or a circular shape. The insulating member 200 may have a curved surface. The insulating member 200 including the first and second insulating members 210 and 220 may have a curved surface. An upper surface of the insulating member 200 may have a curved surface. An edge of the insulating member 200 may have a curved shape.

A portion of each of the first insulating member 210 and the second insulating member 220 may be connected to each other in a central region between the first and second connection members 210 and 220. The first insulating member 210 and the second insulating member 220 are sequentially formed. For example, after forming the first insulating member 210, the second insulating member 220 is formed. In this case, the second insulating member 220 is formed to partially overlap the first insulating member 210 in a vertical direction. Accordingly, the first insulating member 210 and the second insulating member 220 are connected and disposed. The first and second insulating members 210 and 220 may be disposed between the pads 111 and 112 and the bonding pads 134 and 135.

As shown in FIG. 6, the insulating member 200 may include a first insulating member 210, a second insulating member 220, and a third insulating member 230. The first insulating member 210, the second insulating member 220, and the third insulating member 230 may partially contact each other. The first insulating member 210, the second insulating member 220, and the third insulating member 230 are connected. The second insulating member 220 is disposed between the first insulating member 210 and the third insulating member 230 and may be connected to the first insulating member 210 and the third insulating member 230. That is, both end portions of the second insulating member 220 in the second direction X may be connected to one end portion of the first insulating member 210 and the other end portion of the third insulating member 230 or may overlap therewith in a vertical direction.

Each of the first, second, and third insulating members 210, 220, and 230 may have a circular shape or an elliptical shape. The insulating member 200 may include a curved surface. The insulating member 200 including the first, second, and third insulating members 210, 220, and 230 may have a curved surface. An upper surface of the insulating member 200 may have a curved surface. An edge of the insulating member 200 may have a curved shape.

The first insulating member 210 may overlap the first connection member 141 in a vertical direction. The third insulating member 230 may overlap the second connection member 142 in a vertical direction. The second insulating member 220 may overlap at least one or all of the first and second connection members 141 and 142 in a vertical direction.

The first insulating member 210, the second insulating member 220, and the third insulating member 230 are sequentially formed. For example, after forming the first insulating member 210, the second insulating member 220 is formed. In this case, the second insulating member 220 is formed to partially overlap the first insulating member 210. Subsequently, the third insulating member 230 is formed. The third insulating member 230 is formed to partially overlap the second insulating member 220. Accordingly, the first insulating member 210, the second insulating member 220, and the third insulating member 230 are connected and disposed. The insulating member 200 may be disposed between the pads 111 and 112 and the bonding pads 134 and 135. The first to third insulating members 210, 220, and 230 may be disposed between the pads 111 and 112 and the bonding pads 134 and 135.

Referring to FIGS. 4 to 6, the insulating member 200 may not overlap the first pad 111, the second pad 112, the first bonding pad 134, and the second bonding pad 135 in a vertical direction. As shown in FIG. 4, the insulating member 200 is not disposed on the first pad 111 and the second pad 112. More specifically, the insulating member 200 does not contact the first pad 111 and the second pad 112. The insulating member 200 is not disposed on the first bonding pad 134 and the second bonding pad 135. More specifically, the insulating member 200 does not contact the first bonding pad 134 and the second bonding pad 135.

As shown in FIG. 5, the first insulating member 210 and the second insulating member 220 are not disposed on the first pad 111 and the second pad 112. More specifically, the first insulating member 210 and the second insulating member 220 do not contact the first pad 111 and the second pad 112. The first insulating member 210 and the second insulating member 220 are not disposed on the first bonding pad 134 and the second bonding pad 135. More specifically, the first insulating member 210 and the second insulating member 220 do not contact the first bonding pad 134 and the second bonding pad 135.

As shown in FIG. 6, the first insulating member 210, the second insulating member 220, and the third insulating member 230 are not disposed on the first pad 111 and the second pad 112. More specifically, the first insulating member 210, the second insulating member 220, and the third insulating member 230 do not contact the first pad 111 and the second pad 112. The first insulating member 210, the second insulating member 220, and the third insulating member 230 are not disposed on the first bonding pad 134 and the second bonding pad 135. More specifically, the first insulating member 210, the second insulating member 220, and the third insulating member 230 do not contact the first bonding pad 134 and the second bonding pad 135.

As shown in FIG. 4, a top-view shape of the insulating member 200 may be, for example, an elliptical shape. More specifically, the insulating member 200 may have a predetermined width W and length L. The width W is a length in the second direction X and corresponds to a size in a width direction of the connection members 141 and 142. The length L is a length in the first direction Y and corresponds to a size in a length direction of the connection members 141 and 142. The insulating member 200 may be formed in an elliptical shape in which the width W is greater than the length L. That is, when the lighting device is viewed from above, the insulating member 200 may appear to have an elliptical shape. That is, an upper surface of the insulating member 200 may have an elliptical shape.

As shown in FIGS. 5 and 6, the insulating member 200 may be formed in a dumbbell shape or a peanut shape. More specifically, the first insulating member 210 and the second insulating member 220 may each be formed in an elliptical shape. The first insulating member 210 and the second insulating member 220 may each be formed in an elliptical shape in which a width is greater than a length. The first insulating member 210 and the second insulating member 220 overlap each other. Accordingly, the insulating member 200 may be formed in a dumbbell shape or a peanut shape having a small length at a central portion thereof. That is, when the lighting device is viewed from above, the insulating member 200 may have a dumbbell shape or a peanut shape. That is, a bottom shape of the insulating member 200 may have a dumbbell shape or a peanut shape. A side shape of the insulating member 200 may have a hyperbolic shape.

Referring to FIGS. 5, 7, and 8, the insulating member 200 may have a predetermined size. A width W of the insulating member 200 may be greater than or equal to a size of a region in which the first pad 111 and the second pad 112 are disposed and a size of a region in which the first bonding pad 134 and the second bonding pad 135 are disposed. The region in which the first pad 111 and the second pad 112 are disposed may have a first width W1 in the second direction X. In addition, the region in which the first bonding pad 134 and the second bonding pad 135 are disposed may have a second width W2 in the second direction X. The first width W1 and the second width W2 may be different from each other. For example, the second width W2 may be greater than the first width W1. For example, the first width W1 may be 25 mm to 35 mm. In addition, the second width W2 may be 45 mm to 55 mm. The width W of the insulating member may be greater than or equal to the first width W1. More specifically, the width W of the insulating member 200 may be 1 time to 1.5 times the first width W1. When the width W of the insulating member 200 is less than 1 time the first width W1, the first connection member 141 and the second connection member 142 may not be supported by the insulating member 200. Accordingly, the first connection member 141 and the second connection member 142 may be deformed by an external impact. Therefore, reliability of the lighting device may be reduced.

When the width W of the insulating member 200 exceeds 1.5 times the first width W1, an area in which the insulating member 200 is disposed increases. Accordingly, light emitted from the light emitting devices 131 may interfere with the insulating member 200. Accordingly, luminance of the lighting device may be reduced. The width W of the insulating member 200 may be greater than or equal to the second width W2. More specifically, the width W of the insulating member 200 may be 1 time to 1.3 times the second width W2. When the width W of the insulating member 200 is less than 1 time the second width W2, the first connection member 141 and the second connection member 142 may not be supported by the insulating member 200. Accordingly, the first connection member 141 and the second connection member 142 may be deformed by an external impact. Therefore, reliability of the lighting device may be reduced. When the width W of the insulating member 200 exceeds 1.3 times the second width W2, an area in which the insulating member 200 is disposed increases. Accordingly, light emitted from the light emitting devices 131 may interfere with the insulating member 200. Accordingly, luminance of the lighting device may be reduced.

A length L of the insulating member 200 may be less than a length of the connection members 141 and 142. More specifically, the length L of the insulating member 200 may be 50% or more of the length of the connection members 141 and 142. More specifically, the length L of the insulating member 200 may be 50% to 80%, 55% to 75%, or 60% to 70% of the length of the connection members 141 and 142. When the length L of the insulating member 200 is less than 50% of the length of the connection members 141 and 142, an area of the connection members 141 and 142 supported by the insulating member 200 may be reduced. Accordingly, a region of the connection members 141 and 142 not supported by the insulating member 200 may increase. Therefore, support force of the connection members 141 and 142 is reduced. Therefore, the connection members 141 and 142 may be easily deformed by an external impact. Accordingly, electrical connection characteristics between the light source portion 130 and the circuit board 110 may be reduced. Accordingly, reliability of the lighting device may be reduced.

The insulating member 200 may have a predetermined thickness T. The thickness T of the insulating member 200 may be less than or equal to a height H of the connection members 141 and 142. The height H of the connection members 141 and 142 is a distance from the heat dissipation portion 102 to the connection members 141 and 142. For example, the thickness T of the insulating member 200 may be 90% to 100% of the height H of the connection members 141 and 142. Accordingly, the connection members 141 and 142 may contact the insulating member 200. More specifically, the connection members 141 and 142 may include a region contacting the insulating member 200. Accordingly, the connection members 141 and 142 are supported by the insulating member 200. Accordingly, even when a physical force is externally applied, deformation of the connection members 141 and 142 may be prevented. When a physical force is externally applied, shapes of the connection members 141 and 142 may be changed to have a concave shape. Accordingly, bonding force among the connection members 141 and 142, the pads 111 and 112, and the bonding pads 134 and 135 may be reduced. Alternatively, connection among the connection members 141 and 142, the pads 111 and 112, and the bonding pads 134 and 135 may be disconnected.

Deformation of the connection members 141 and 142 is restricted by the insulating member 200. Therefore, even when a physical force is externally applied, deformation of the connection members 141 and 142 may be minimized. Therefore, reduction in bonding force among the connection members 141 and 142, the pads 111 and 112, and the bonding pads 134 and 135 due to an external force may be prevented.

As another example, the connection members 141 and 142 may be spaced apart from the insulating member 200. More specifically, the connection members 141 and 142 may not include a region contacting the insulating member 200. Accordingly, deformation of the connection members 141 and 142 is restricted by the insulating member 200. More specifically, even when a physical force is externally applied, deformation of the connection members 141 and 142 is limited to a region contacting the insulating member 200. Therefore, deformation of the connection members 141 and 142 may be minimized. Therefore, reduction in bonding force among the connection members 141 and 142, the pads 111 and 112, and the bonding pads 134 and 135 due to an external force may be prevented.

The connection members 141 and 142 do not contact the insulating member 200. The lighting device generates heat during operation. The connection members 141 and 142 and the insulating member 200 include different materials. Accordingly, the connection members 141 and 142 and the insulating member 200 have different coefficients of thermal expansion. Therefore, amounts of deformation of the connection members 141 and 142 and the insulating member 200 may differ at the same temperature. Therefore, the connection members 141 and 142 and the insulating member 200 do not contact each other. Accordingly, deformation of the connection members 141 and 142 by the insulating member 200 may be prevented.

The thickness T of the insulating member 200 may be 90% or more of the height H of the connection members 141 and 142. When the thickness T of the insulating member 200 is less than 90% of the height H of the connection members 141 and 142, deformation of the connection members 141 and 142 due to an external impact may increase. Accordingly, bonding force among the connection members 141 and 142, the pads, and the bonding pads may be reduced.

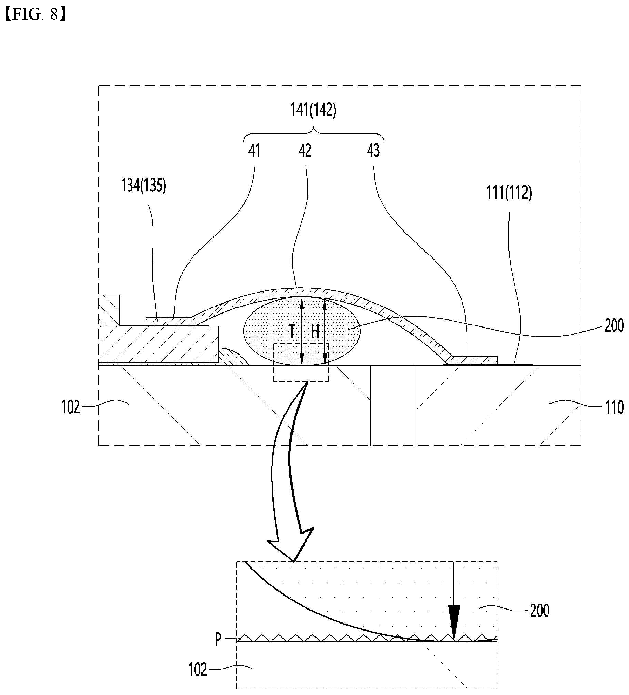

Referring to FIG. 8, the heat dissipation portion 102 may include patterns P. The insulating member 200 is formed in a droplet shape. Accordingly, a contact area between the insulating member 200 and the heat dissipation portion 102 is reduced. Therefore, adhesion force of the insulating member 200 may be reduced. Accordingly, a plurality of patterns P may be formed on a surface of the heat dissipation portion 102. The insulating member 200 may contact the patterns P. The contact area between the insulating member 200 and the heat dissipation portion 102 may be increased by the patterns P. Therefore, adhesion force of the insulating member 200 may increase. Therefore, peeling of the insulating member 200 may be prevented. Accordingly, reliability of the lighting device may be improved.

The lighting device according to the first embodiment includes an insulating member. The insulating member supports the connection members. The connection members contact the insulating member. Accordingly, deformation of the connection members due to an external impact may be prevented. Therefore, bonding force among the connection members, the pads, and the bonding pads is improved. The connection members are spaced apart from the insulating member within a predetermined range. Accordingly, deformation of the connection members due to an external impact may be prevented. Therefore, bonding force among the connection members, the pads, and the bonding pads is improved. In addition, the connection members do not contact the insulating member. Accordingly, deformation of positions of the connection members due to a difference in coefficients of thermal expansion between the connection members and the insulating member may be prevented. Therefore, bonding force among the connection members, the pads, and the bonding pads is improved.

Hereinafter, a lighting device according to a second embodiment will be described with reference to the drawings. Descriptions similar to those of the lighting device according to the first embodiment described above will be omitted.

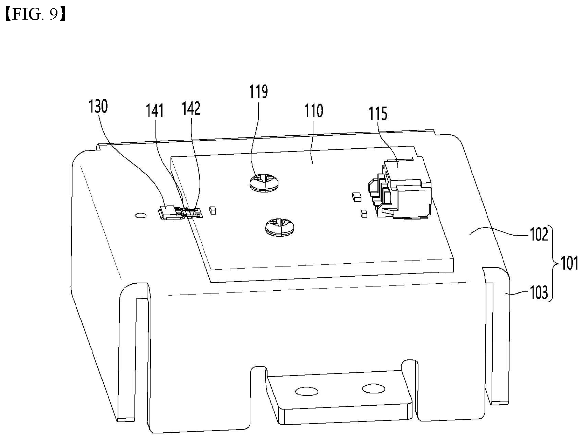

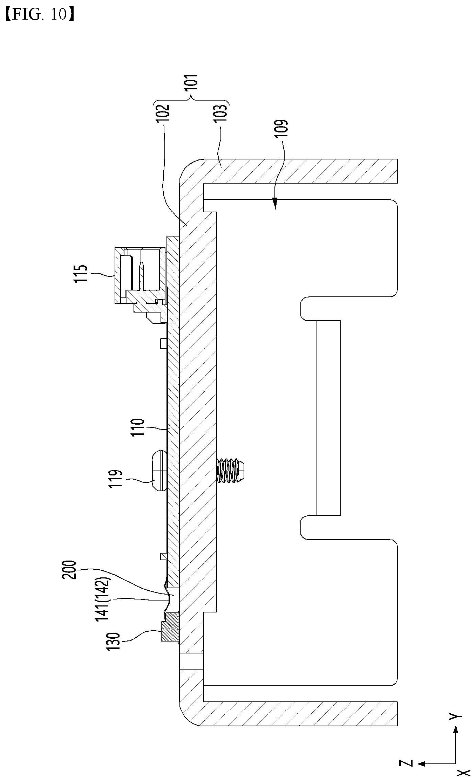

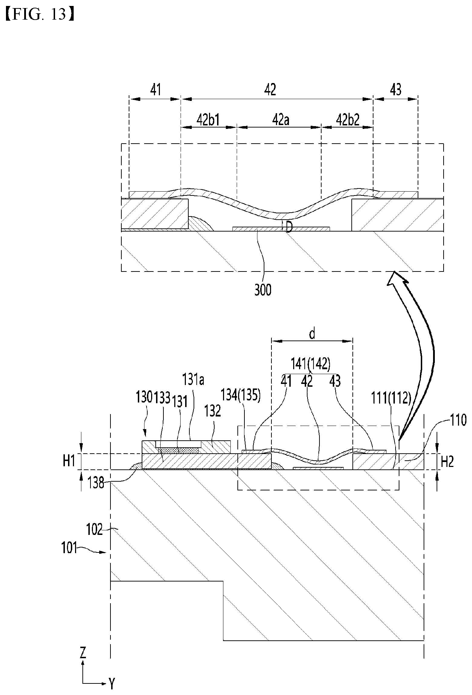

Referring to FIGS. 9 to 20, the lighting device according to the second embodiment includes a heat dissipation plate 101, a circuit board 110, a light source portion 130, and connection members 141 and 142. Unlike the lighting device according to the first embodiment disclosed above, the lighting device according to the second embodiment does not include a recess portion. Accordingly, the circuit board 110 is disposed on the heat dissipation portion 102. The circuit board 110 is disposed on the same plane as the light source portion 130. The circuit board 110 is disposed spaced apart from the light source portion 130.

Although not shown in the drawings, an adhesive may be disposed between the circuit board 110 and the heat dissipation portion 102. The circuit board 110 may be bonded to the heat dissipation portion 102 by the adhesive. The light source portion 130 and the circuit board 110 are electrically connected by the first connection member 141 and the second connection member 142. The connection members 141 and 142 include wires. Accordingly, the connection members 141 and 142 may be damaged by an external impact. In addition, when the connection members 141 and 142 are exposed to the outside, the connection members 141 and 142 may react with substances in the air and be corroded. Accordingly, electrical connection characteristics between the light source portion 130 and the circuit board 110 may be reduced. In order to solve the above-described problems, the lighting device according to the embodiment controls shapes of the connection members.

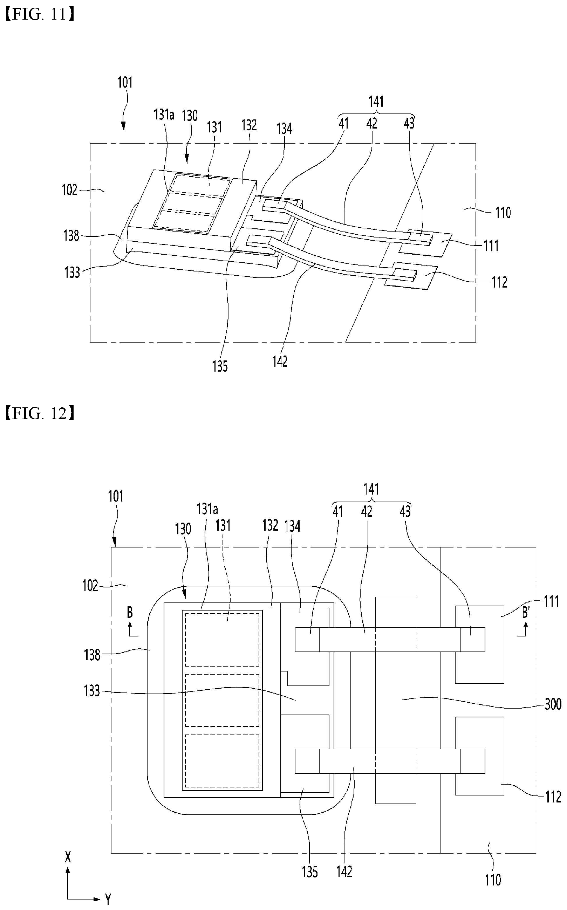

Referring to FIGS. 11 to 14, the connection members 141 and 142 may have a concave shape. More specifically, the connection members 141 and 142 may have a shape convex downward. The connection members 141 and 142 include the one end 41, the other end 43, and the connection portion 42. The connection portion 42 may include a concave portion. More specifically, the connection portion 42 may have a shape convex toward the heat dissipation plate 101 or may be a convex portion.

The connection portion 42 of the connection members 141 and 142 may include a central portion 42a and outer portions. The outer portions may include a first outer portion 42b1 and a second outer portion 42b2. The first outer portion 42b1 may be adjacent to the bonding pads 134 and 135. The second outer portion 42b2 may be adjacent to the pads 111 and 112. The central portion 42a is a region disposed between the light source portion 130 and the circuit board 110. More specifically, the central portion 42a is a region disposed between a side surface of the support member 133 and a side surface of the circuit board 110. The first outer portion 42b1 and the second outer portion 42b2 are regions disposed outside the region between the side surface of the support member 133 and the side surface of the circuit board 110. The central portion 42a may be concave. More specifically, the central portion 42a may be convex downward. The central portion 42a may be convex toward the heat dissipation plate 101. The outer portions 42b1 and 42b2 may be convex. More specifically, the outer portions 42b1 and 42b2 may be convex upward. More specifically, the outer portions 42b1 and 42b2 may be convex in a direction opposite to the heat dissipation plate 101.

Accordingly, the connection portion 42 of the connection members 141 and 142 may be convex upward and then convex downward while extending from the bonding pads 134 and 135 to the pads 111 and 112, and may have multiple convex portions. That is, the connection portion 42 may be formed in a shape in which an upward convex portion, a downward convex portion, and an upward convex portion are sequentially connected. A length of the central portion 42a may be greater than a length of at least one of the first outer portion 42b1 and the second outer portion 42b2. For example, the length of the central portion 42a may be greater than the length of the first outer portion 42b1. Alternatively, the length of the central portion 42a may be greater than the length of the second outer portion 42b2. Alternatively, the length of the central portion 42a may be greater than a sum of the lengths of the first outer portion 42b1 and the second outer portion 42b2. For example, the length of the central portion 42a may be 30% or more of the length of the connection members 141 and 142. More specifically, the length of the central portion 42a may be 30% to 70%, 35% to 65%, or 40% to 60% of the length of the connection members 141 and 142. When the length of the central portion 42a is less than 30% of the length of the connection members 141 and 142, a region convex in a direction opposite to the heat dissipation plate may increase. Accordingly, the connection members may be damaged by an external impact. When the length of the central portion 42a exceeds 70% of the length of the connection members 141 and 142, curvature of the central portion 42a may increase. Accordingly, cracks may be formed in the connection members. In addition, the connection members and the heat dissipation portion may contact each other.

A length of at least one of the outer portions 42b1 and 42b2 of the connection members 141 and 142 may be 15% or more of the length of the connection members 141 and 142. More specifically, the length of at least one of the outer portions 42b1 and 42b2 may be 15% to 35%, 20% to 30%, or 22% to 28% of the length of the connection members 141 and 142. When the length of the outer portions 42b1 and 42b2 is less than 15% of the length of the connection members 141 and 142, connection characteristics between the connection members 141 and 142 and the bonding pads 134 and 135 and connection characteristics between the connection members 141 and 142 and the pads 111 and 112 may be reduced. When the length of the outer portions 42b1 and 42b2 exceeds 30% of the length of the connection members 141 and 142, the length of the connection members 141 and 142 may increase. Accordingly, a size of the lighting device may increase due to the connection members 141 and 142.

Within the length range of the central portion and the outer portions of the connection members 141 and 142, the length of the central portion 42a may be greater than a length of at least one of the first outer portion 42b1 and the second outer portion 42b2. For example, the length of the central portion 42a may be greater than the length of the first outer portion 42b1. Alternatively, the length of the central portion 42a may be greater than the length of the second outer portion 42b2. Alternatively, the length of the central portion 42a may be greater than a sum of the lengths of the first outer portion 42b1 and the second outer portion 42b2. That is, most regions of the connection members 141 and 142 may be formed in a shape convex downward. Therefore, regions of the connection members 141 and 142 may be disposed between the light source portion 130 and the circuit board 110.

The connection members 141 and 142 may be protected due to the shapes thereof. That is, even when an external impact is transmitted, the connection members 141 and 142 may be protected by the light source portion 130 and the circuit board 110. More specifically, since regions of the connection members 141 and 142 are disposed between the light source portion 130 and the circuit board 110, transmission of an external impact to the connection members 141 and 142 may be prevented. Therefore, damage to the connection members 141 and 142 due to an external impact may be prevented.

The light source portion 130 and the circuit board 110 may be spaced apart from each other. The light source portion 130 and the circuit board 110 may be spaced apart from each other by a predetermined distance. A distance d in the first direction between the light source portion 130 and the circuit board 110 may be 60% or more of a length of the connection members 141 and 142. More specifically, the distance d between the light source portion 130 and the circuit board 110 may be 60% to 90%, 65% to 85%, or 70% to 80% of the length of the connection members 141 and 142.

When the distance d between the light source portion 130 and the circuit board 110 is less than 60% of the length of the connection members 141 and 142, the size of the distance d between the light source portion 130 and the circuit board 110 becomes narrow. Accordingly, curvature of the central portion 42a may increase. Accordingly, cracks may be formed in the connection members. In addition, the connection members and the heat dissipation portion may contact each other. When the distance d between the light source portion 130 and the circuit board 110 exceeds 80% of the length of the connection members 141 and 142, the length of the connection members may increase. Accordingly, a size of the lighting device may increase due to the connection members.

The connection members 141 and 142 may be spaced apart from the heat dissipation portion 102. The connection members 141 and 142 and the heat dissipation plate 101 may be spaced apart from each other by a predetermined distance. A minimum distance D in the third direction Z between the connection members 141 and 142 and the heat dissipation portion 102 may be 0.1 mm or more. The minimum distance D between the connection members 141 and 142 and the heat dissipation portion 102 may be less than thicknesses of the support member 133 and the circuit board 110. For example, the minimum distance D between the connection members 141 and 142 and the heat dissipation portion 102 may be 0.1 mm to 2 mm.

A center of the central portion 42a of the connection members 141 and 142 may be defined. More specifically, the center of the central portion 42a may be defined as a region where a distance between the central portion 42a and the heat dissipation portion is smallest. The center of the central portion 42a may be positioned at or adjacent to a 1/2 point of the length of the central portion 42a. More specifically, the center of the central portion 42a may be disposed within a region of ±10% from the 1/2 point of the length of the central portion 42a. Accordingly, excessive bending of the connection portion 42 in one direction may be prevented. Therefore, cracks in the connection members may be prevented.

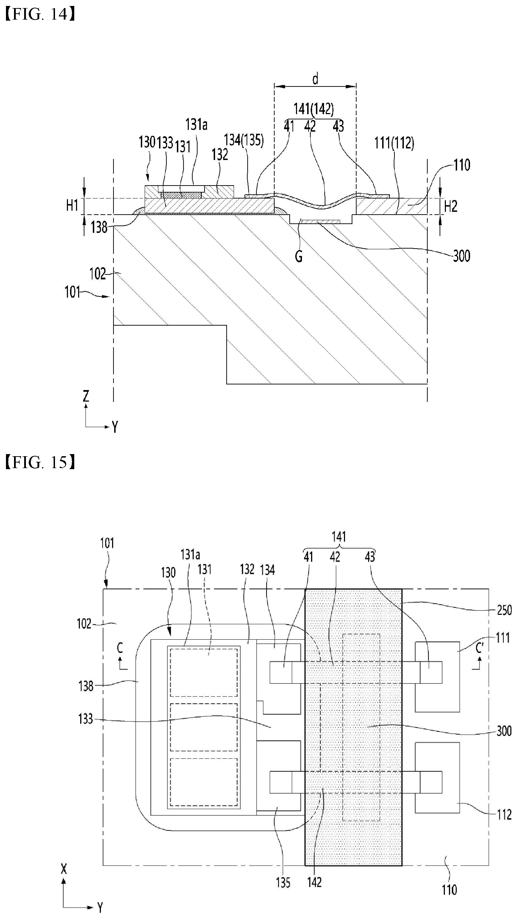

Referring to FIG. 14, the heat dissipation plate 101 may include a groove. More specifically, the heat dissipation portion 102 may include a groove G. The groove G is disposed between the light source portion 130 and the circuit board 110. Therefore, the groove G may overlap the connection members 141 and 142. More specifically, the groove G may overlap the central portion 42a. Accordingly, contact between the connection members 141 and 142 and the heat dissipation plate 101 may be prevented.

Since the heat dissipation plate 101 is made of a conductive material, when the connection members 141 and 142 contact the heat dissipation plate 101, a short circuit between the circuit board 110 and the light source portion 130 may occur. Accordingly, reliability of the lighting device may be reduced. Therefore, the heat dissipation portion 102 includes the groove G. Accordingly, during a process of forming the connection members 141 and 142, contact between the central portion 42a and the heat dissipation portion 102 may be prevented. That is, the minimum distance D between the connection members 141 and 142 and the heat dissipation portion 102 may increase. Alternatively, after forming the connection members 141 and 142, contact between the central portion 42a and the heat dissipation portion 102 due to an external impact may be prevented. Therefore, reliability of the lighting device is improved.

A height of an upper surface of the light source portion 130 may differ from a height of an upper surface of the circuit board 110. A height H1 of the upper surface of the light source portion 130 is a height from the heat dissipation portion 102 to an upper surface of the support member 133. A height H2 of the upper surface of the circuit board 110 is a height from the heat dissipation portion 102 to an upper surface of the circuit board 110. The height H1 of the upper surface of the light source portion 130 and the height H2 of the upper surface of the circuit board 110 may be identical or similar. More specifically, the height H1 of the upper surface of the light source portion 130 may be 90% to 110% of the height H2 of the upper surface of the circuit board 110. When the height H1 of the upper surface of the light source portion 130 and the height H2 of the upper surface of the circuit board 110 are outside the above range, lengths of the outer portions 42b1 and 42b2 may increase. Accordingly, lengths of the connection members 141 and 142 disposed in regions other than the region between the side surface of the light source portion 130 and the side surface of the circuit board 110 may increase. Accordingly, the connection members 141 and 142 may be damaged by an external impact.

The lighting device may further include an insulating member 300. The insulating member 300 is disposed between the light source portion 130 and the circuit board 110. The insulating member 300 is disposed on the heat dissipation portion 102. The insulating member 300 is disposed at a lower portion of the connection members 141 and 142. The insulating member 300 is disposed at a lower portion of the central portion 42a. The insulating member 300 faces the connection members 141 and 142. The insulating member 300 faces the central portion 42a. As shown in FIG. 14, the insulating member 300 may be disposed inside the groove G of the heat dissipation plate. The groove G of the heat dissipation plate has a long length in the second direction Y and may overlap the connection members 141 and 142 in a vertical direction. The connection members 141 and 142 are disposed concave toward the heat dissipation portion 102. Accordingly, the central portion 42a is disposed adjacent to the heat dissipation portion 102. Therefore, when handling the lighting device, the connection members 141 and 142 may contact the heat dissipation portion 102. Alternatively, the connection members 141 and 142 may contact the heat dissipation portion 102 due to an external impact. Since both the connection members 141 and 142 and the heat dissipation portion 102 are conductive materials, a short circuit may occur when the connection members 141 and 142 contact the heat dissipation portion 102. Therefore, reliability of the lighting device is reduced. Accordingly, the insulating member 300 is disposed on the heat dissipation portion 102. Accordingly, contact between the connection members 141 and 142 and the heat dissipation portion 102 due to deformation of the connection members 141 and 142 may be prevented. More specifically, even when the connection members 141 and 142 move closer to the heat dissipation portion 102 due to an external impact, the connection members 141 and 142 do not contact the heat dissipation portion 102 due to the insulating member 300. Therefore, electrical connection between the connection members 141 and 142 and the heat dissipation portion 102 may be prevented.

The connection members 141 and 142 include metal. Accordingly, the connection members 141 and 142 may be corroded by external moisture. In addition, the connection members 141 and 142 may be separated from the bonding pads 134 and 135 or the pads 111 and 112 due to an external impact. Alternatively, after forming the connection members 141 and 142, the central portion 42a and the heat dissipation portion 102 may contact each other due to an external impact. In order to solve the above-described problems, the lighting device according to the embodiment may further include a molding portion 250.

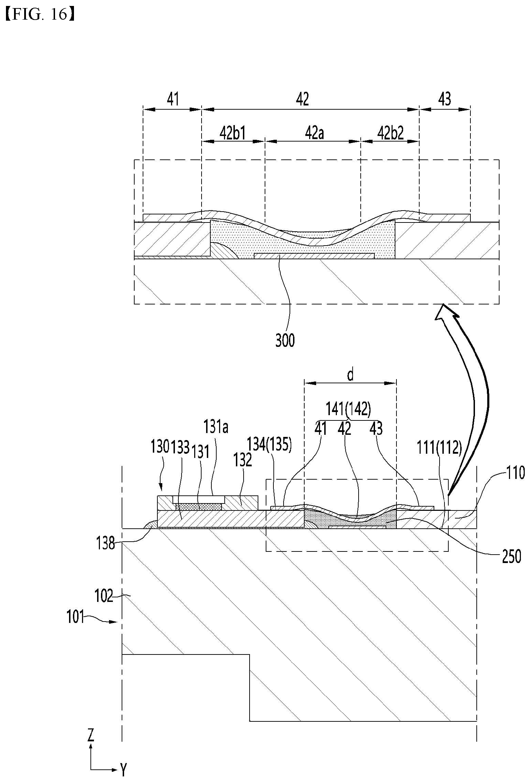

Referring to FIGS. 15 and 16, the lighting device may include a molding portion 250. The molding portion 250 is disposed between the light source portion 130 and the circuit board 110.

The molding portion 250 may surround the connection members 141 and 142. More specifically, the molding portion 250 may surround partial regions of the connection members 141 and 142. More specifically, the molding portion 250 may surround the connection portion 42. More specifically, the molding portion 250 may surround partial regions of the connection portion 42. More specifically, the molding portion 250 may surround the central portion 42a. The outer portions 42b1 and 42b2 may be disposed outside the molding portion 250. The central portion 42a occupies most regions of the connection members 141 and 142. Therefore, the molding portion 250 may surround most regions of the connection members 141 and 142. Therefore, corrosion of the connection members 141 and 142 by external moisture may be prevented. More specifically, a corrosion rate of the connection members 141 and 142 may be reduced. In addition, separation of the connection members 141 and 142 from the bonding pads 134 and 135 or the pads 111 and 112 due to an external impact may be prevented. Therefore, reliability of the lighting device is improved. After forming the connection members 141 and 142, contact between the central portion 42a and the heat dissipation portion 102 due to an external impact may be prevented. Therefore, electrical characteristics of the lighting device may be improved.

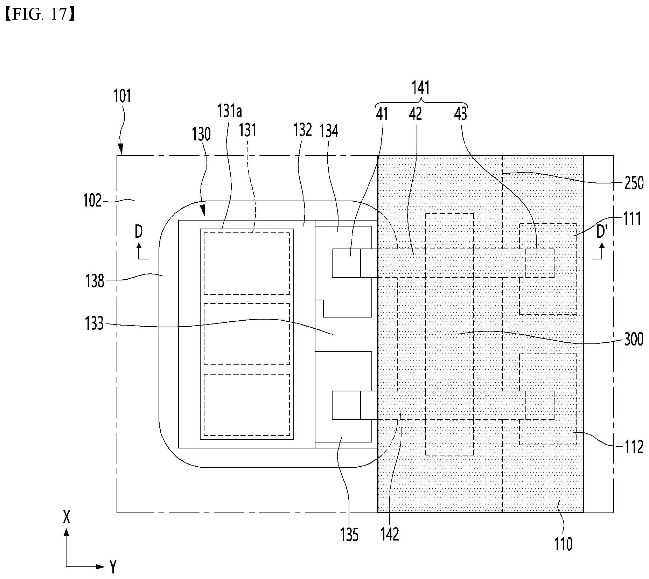

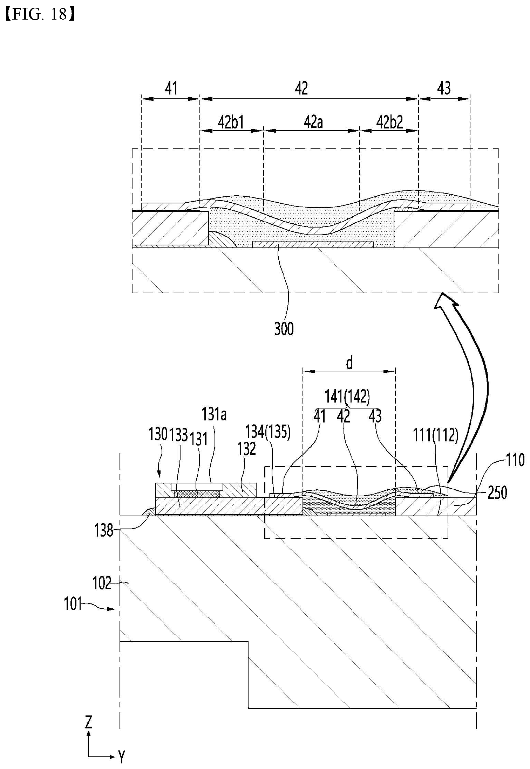

Referring to FIGS. 17 and 18, the lighting device may include a molding portion 250. The molding portion 250 is disposed between the light source portion 130 and the circuit board 110. In addition, the molding portion 250 is disposed on the circuit board 110. More specifically, the molding portion 250 is disposed on the pads 111 and 112. The molding portion 250 may surround the connection members 141 and 142. More specifically, the molding portion 250 may surround partial regions of the connection members 141 and 142. More specifically, the molding portion 250 may surround the connection portion 42. More specifically, the molding portion 250 may surround partial regions of the connection portion 42. More specifically, the molding portion 250 may surround the central portion 42a and the second outer portion 42b2. The first outer portion 42b1 may be disposed outside the molding portion 250. The central portion 42a occupies most regions of the connection members 141 and 142. Therefore, the molding portion 250 may surround most regions of the connection members 141 and 142.

The molding portion 250 may prevent corrosion of the connection members 141 and 142 by external moisture. More specifically, a corrosion rate of the connection members 141 and 142 may be reduced. In addition, separation of the connection members 141 and 142 from the bonding pads 134 and 135 or the pads 111 and 112 due to an external impact may be prevented. Therefore, reliability of the lighting device is improved. In addition, after forming the connection members 141 and 142, contact between the central portion 42a and the heat dissipation portion 102 due to an external impact may be prevented. Therefore, electrical characteristics of the lighting device may be improved. The molding portion 250 surrounds the second outer portion 42b2. The second outer portion 42b2 is disposed in a region other than a region between the light source portion 130 and the circuit board 110. Accordingly, the second outer portion 42b2 may be more vulnerable to an external impact than the central portion 42a. Since the molding portion 250 is disposed while surrounding the second outer portion 42b2, damage to the second outer portion due to an external impact may be prevented. The molding portion 250 may surround the pads 111 and 112. More specifically, the molding portion 250 may surround a bonding region between the connection members 141 and 142 and the pads 111 and 112. Therefore, disconnection between the connection members 141 and 142 and the pads 111 and 112 may be prevented.

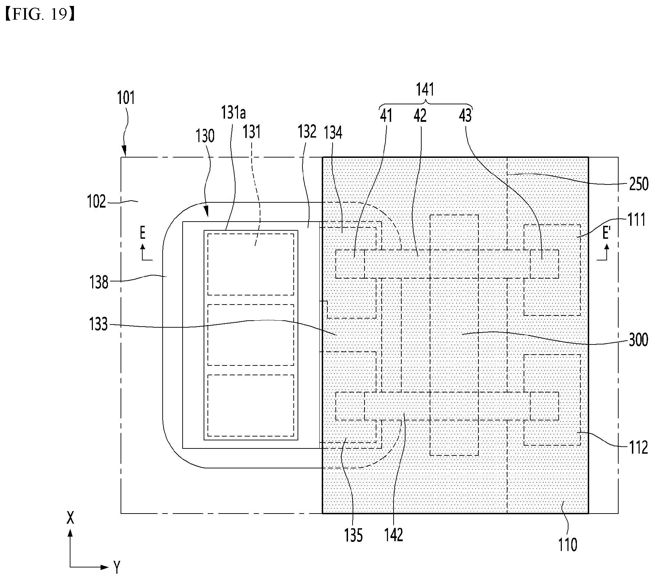

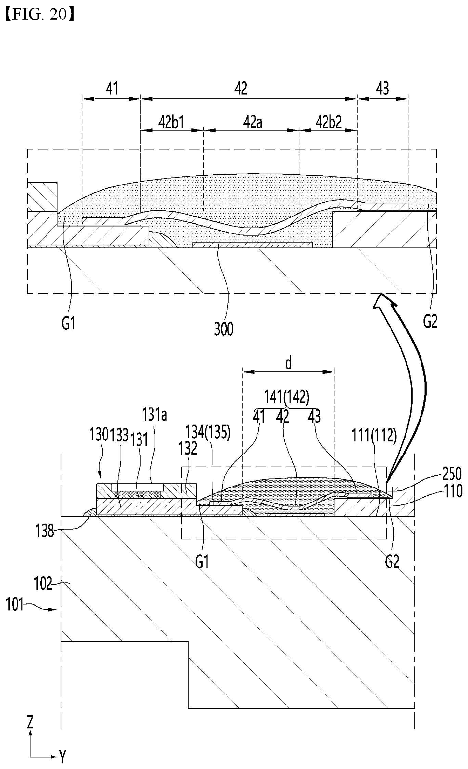

Referring to FIGS. 19 and 20, the lighting device may include a molding portion 250. The molding portion 250 is disposed between the light source portion 130 and the circuit board 110. In addition, the molding portion 250 is disposed on the circuit board 110. More specifically, the molding portion 250 is disposed on the pads 111 and 112. In addition, the molding portion 250 is disposed on the light source portion 130. More specifically, the molding portion 250 is disposed on the support member 133. More specifically, the molding portion 250 is disposed on the bonding pads 134 and 135. The molding portion 250 may surround the connection members 141 and 142. More specifically, the molding portion 250 may surround entire regions of the connection members 141 and 142.

The molding portion 250 may surround the connection portion 42. More specifically, the molding portion 250 may surround entire regions of the connection portion 42. More specifically, the molding portion 250 may surround the central portion 42a, the first outer portion 42b1, and the second outer portion 42b2. Therefore, corrosion of the connection members 141 and 142 by external moisture may be prevented. More specifically, a corrosion rate of the connection members 141 and 142 may be reduced. In addition, separation of the connection members 141 and 142 from the bonding pads 134 and 135 or the pads 111 and 112 due to an external impact may be prevented. Therefore, reliability of the lighting device is improved.

After forming the connection members 141 and 142, contact between the central portion 42a and the heat dissipation portion 102 due to an external impact may be prevented. Therefore, electrical characteristics of the lighting device may be improved. The molding portion 250 surrounds the first outer portion 42b1. The first outer portion 42b1 is disposed in a region other than a region between the light source portion 130 and the circuit board 110. Accordingly, the first outer portion 42b1 may be more vulnerable to an external impact than the central portion 42a. Since the molding portion 250 is disposed while surrounding the first outer portion 42b1, damage to the first outer portion due to an external impact may be prevented.

The molding portion 250 surrounds the second outer portion 42b2. The second outer portion 42b2 is disposed in a region other than a region between the light source portion 130 and the circuit board 110. Accordingly, the second outer portion 42b2 may be more vulnerable to an external impact than the central portion 42a. Since the molding portion 250 is disposed while surrounding the second outer portion 42b2, damage to the second outer portion due to an external impact may be prevented.

The light source portion 130 and the circuit board 110 may include grooves. More specifically, the light source portion 130 may include a first groove G1. The first groove G1 may be formed on an upper surface of the support member 133. The circuit board 110 may include a second groove G2. The bonding pads 134 and 135 may be disposed inside the first groove G1. In addition, the pads 111 and 112 may be disposed inside the second groove G2.

The molding portion 250 may surround the bonding pads 134 and 135. More specifically, the molding portion 250 may surround the one end 41. More specifically, the molding portion 250 may surround a bonding region between the connection members 141 and 142 and the bonding pads 134 and 135. Therefore, disconnection between the connection members 141 and 142 and the bonding pads 134 and 135 may be prevented. The bonding pads 134 and 135 are disposed inside the first groove G1. Therefore, movement of the molding portion 250 toward the light emitting devices 131 may be prevented. That is, the molding portion 250 may contact only lower portions of side surfaces of the light emitting devices 131 facing the circuit board 110, or may be disposed spaced apart from the side surfaces of the light emitting devices 131. Accordingly, interference between light emitted from the light emitting devices 131 and the molding portion 250 may be prevented. Therefore, luminance of the lighting device may be improved.

The molding portion 250 may surround the pads 111 and 112. More specifically, the molding portion 250 may surround the other end 43. More specifically, the molding portion 250 may surround a bonding region between the connection members 141 and 142 and the pads 111 and 112. Therefore, disconnection between the connection members 141 and 142 and the pads 111 and 112 may be prevented. The pads 111 and 112 are disposed inside the second groove G2. Therefore, a size of the molding portion moving toward the circuit board 110 may be controlled. Therefore, a bezel region of the circuit board is reduced. Therefore, a size of the lighting device may be reduced.

Referring to FIGS. 15 to 20, the insulating member 300 is covered by the molding portion 250. The insulating member 300 and the molding portion 250 may include the same material. Alternatively, the insulating member 300 and the molding portion 250 may include materials having similar coefficients of thermal expansion. Since the insulating member 300 and the molding portion 250 have similar coefficients of thermal expansion, formation of a void between the insulating member 300 and the molding portion 250 due to separation of the insulating member 300 and the molding portion 250 caused by heat generated during operation of the lighting device may be prevented.

Since the connection members 141 and 142 are metal and the molding portion 250 is made of a non-metal material, coefficients of thermal expansion of the connection members 141 and 142 and the molding portion 250 are different. Accordingly, shapes or positions of the connection members 141 and 142 may be deformed due to heat generated during operation of the lighting device. Accordingly, the connection members 141 and 142 may move toward the heat dissipation portion 102 such that the connection members 141 and 142 contact the heat dissipation portion 102. The insulating member 300 is disposed on the heat dissipation portion 102. Accordingly, even when shapes or positions of the connection members 141 and 142 are deformed due to a difference in coefficients of thermal expansion between the connection members 141 and 142 and the molding portion 250, contact between the connection members 141 and 142 and the heat dissipation portion 102 may be prevented. Therefore, reliability of the lighting device is improved.

The lighting device according to the second embodiment includes connection members. The connection members connect the light source portion and the circuit board. More specifically, the connection members are connected to the bonding pads and the pads. The connection members include one end, the other end, and a connection portion. The connection portion connects the one end and the other end. The connection portion includes a central portion and outer portions. The central portion occupies most regions of the connection portion. The central portion is formed concave. More specifically, the central portion is formed convex downward. Therefore, the central portion is disposed in a region between the light source portion and the circuit board. Therefore, when an external impact is transmitted, the central portion may be protected by the light source portion and the circuit board. Therefore, damage to the connection members due to an external impact may be prevented. Therefore, reliability of the lighting device may be improved.

The lighting device may further include a molding portion. The molding portion may be disposed while surrounding at least one of the connection portion, the one end, and the other end. Therefore, corrosion of the connection members may be prevented. In addition, fixing force of the connection members may be improved. In addition, short-circuiting among the connection members, the bonding pads, and the pads may be prevented.

In addition, the light source portion includes the first groove, and the circuit board includes the second groove. The bonding pads are disposed inside the first groove, and the pads are disposed inside the second groove. An area of the molding portion is controlled by the first groove and the second groove. Therefore, movement of the molding portion toward the light source portion may be prevented. Therefore, luminance of the lighting device may be improved. In addition, increase in a bezel region of the circuit board due to the molding portion may be prevented. Therefore, a size of the lighting device may be reduced. In addition, the lighting device includes the insulating member on the heat dissipation portion. Accordingly, even when shapes or positions of the connection members are deformed due to an external impact or a difference in coefficients of thermal expansion from the molding portion, contact between the connection members and the heat dissipation portion may be prevented. Accordingly, since electrical connection between the connection members and the heat dissipation portion is prevented, reliability of the lighting device is improved.

The lighting device may be applied to lighting of a movable object such as a vehicle or a drone. In addition, the lighting device may be applied to various types of vehicle lighting, for example, a head lamp.

Features, structures, effects, and the like described in the above embodiments are included in at least one embodiment of the invention and are not necessarily limited to only one embodiment. Furthermore, features, structures, effects, and the like illustrated in each embodiment may be combined or modified with respect to other embodiments by those skilled in the art to which the embodiments pertain. Accordingly, contents related to such combinations and modifications should be construed as being included within the scope of the invention. In addition, although the embodiments have been mainly described above, the embodiments are merely examples and do not limit the invention. Those skilled in the art to which the invention pertains will appreciate that various modifications and applications not illustrated above may be made without departing from the essential characteristics of the embodiments. For example, each component specifically shown in the embodiments may be modified and implemented. In addition, differences related to such modifications and applications should be construed as being included within the scope of the invention as defined by the appended claims.

## Claims

1. A lighting device comprising:
a heat dissipation plate including a recess portion;
a circuit board disposed in the recess portion and having a plurality of pads;
a light source portion disposed on the heat dissipation plate and including a plurality of light emitting devices and a plurality of bonding pads;
a plurality of connection members connecting the circuit board and the light source portion; and
an insulating member disposed at a lower portion of the connection members,
wherein the circuit board and the light source portion are spaced apart from each other in a first direction,
wherein the plurality of connection members is spaced apart from each other in a second direction orthogonal to the first direction,
wherein the plurality of connection members is respectively connected between the plurality of pads and the plurality of bonding pads,
wherein the insulating member is disposed between the light source portion and the circuit board, and
wherein the insulating member does not contact the pads and the bonding pads.

2. The lighting device of claim 1,
wherein the insulating member contacts the plurality of connection members.

3. The lighting device of claim 1,
wherein the insulating member does not contact the plurality of connection members.

4. The lighting device of any one of claims 1 to 3,
wherein a thickness of the insulating member is 90% or more of a height of the plurality of connection members, and
wherein a height of the plurality of connection members is a distance from the heat dissipation plate to the connection members.

5. The lighting device of any one of claims 1 to 3,
wherein a region in which the plurality of pads is disposed has a first width in the second direction,
wherein a region in which the plurality of bonding pads is disposed has a second width in the second direction,
wherein a width of the insulating member in the second direction is 1 time to 1.5 times the first width, and
wherein the width of the insulating member is 1 time to 1.3 times the second width.

6. The lighting device of any one of claims 1 to 3,
wherein a length of the insulating member in the first direction is 50% to 80% of a length of the connection members.

7. The lighting device of claim 1,
wherein the heat dissipation plate includes a plurality of patterns, and
wherein the insulating member contacts the patterns.

8. A lighting device comprising:
a heat dissipation plate;
a circuit board disposed on the heat dissipation plate and having a plurality of pads;
a light source portion disposed on the heat dissipation plate and including a plurality of light emitting devices and a plurality of bonding pads;
a plurality of connection members connecting the circuit board and the light source portion; and
an insulating member disposed on the heat dissipation plate,
wherein the circuit board and the light source portion are spaced apart from each other in a first direction,
wherein the plurality of connection members is spaced apart from each other in a second direction orthogonal to the first direction,
wherein each of the plurality of connection members includes:
one end connected to the plurality of bonding pads;
the other end connected to the plurality of pads; and
a connection portion connecting the one end and the other end,
wherein the connection portion includes a convex portion convex toward the heat dissipation plate, and
wherein the insulating member is disposed at a lower portion of the plurality of connection members.

9. The lighting device of claim 8, further comprising:
a molding portion surrounding the plurality of connection members.

10. The lighting device of claim 9,
wherein the molding portion and the insulating member include the same material.

11. The lighting device of claim 8,
wherein the light source portion includes a support member,
wherein the light emitting devices are disposed on the support member,
wherein the connection portion includes a central portion, a first outer portion, and a second outer portion,
wherein the central portion is disposed in a region between a side surface of the support member and a side surface of the circuit board, and
wherein the first outer portion and the second outer portion are disposed in regions other than the region between the side surface of the support member and the side surface of the circuit board.

12. The lighting device of claim 11,
wherein the central portion is convex toward the heat dissipation plate, and
wherein the first outer portion and the second outer portion are convex in a direction opposite to the heat dissipation plate.

13. The lighting device of claim 8,
wherein the heat dissipation plate includes a groove having a long length in the second direction, and
wherein the groove is disposed between the light source portion and the circuit board.

14. The lighting device of claim 13,
wherein the insulating member is disposed inside the groove and overlaps the plurality of connection members in a vertical direction.
